# EUROPÄISCHE PATENTSCHRIFT

(11) **EP 0 512 124 B1**
(45) Veröffentlichungstag und Bekanntmachung des Hinweises auf die Patenterteilung: **29.03.1995**
(21) Anmeldenummer: 91107068.8
(22) Anmeldetag: 02.05.1991
(51) Int. Cl.: H01H 13/70, H03K 17/96

(54) **Tastatur**
Keyboard
Clavier

(43) Veröffentlichungstag der Anmeldung: 11.11.1992
(73) Patentinhaber: SCHEIDT & BACHMANN GMBH, D-41238 Mönchengladbach (DE)
(72) Erfinder: Miller, Gert, Dipl.Ing., W-4050 Mönchengladbach 1 (DE); Sauermann, Michael, Dipl.Ing., W-4050 Mönchengladbach 4 (DE)
(74) Vertreter: Stenger, Watzke & Ring Patentanwälte

(56) Entgegenhaltungen:
- EP-A- 0 210 386
- CH-A- 675 028
- US-A- 4 618 797
- US-A- 4 640 994

## Beschreibung

Die Erfindung betrifft eine Tastatur mit einer Mehrzahl von scheibenförmigen, jeweils auf einem Metallplättchen angeordneten Piezo-Elementen, die hinter einer mit Tastensymbolen versehenen Abdeckfolie in Aussparungen einer eine starre Trägerplatte umfassenden Unterlage und jeweils zwischen zwei Kontaktflächen angeordnet sind, die über Leiterbahnen mit einem Anschluß der Tastatur verbunden sind.

Derartige, als Folientastatur bezeichnete Tastaturen sind beispielsweise aus der EP-A 210 386 bekannt. Sie haben den Vorteil, daß sie aufgrund ihres Aufbaues aus mehreren Folien preiswert hergestellt und auf verhältnismäßig einfache Weise an den jeweiligen Verwendungszweck angepaßt werden können.

Bei der aus der EP-A 210 386 bekannten Folientastatur wird zur Aufnahme der Piezo-Elemente eine zwischen zwei Deckfolien angeordnete Zwischenfolie verwendet, die mit entsprechenden Aussparungen für die einzelnen Piezo-Elemente versehen ist. Diese Zwischenfolie stellt nicht nur ein zusätzliches Bauteil dar, sondern muß zur Erfüllung ihres Zweckes mit einer Dicke hergestellt werden, die im wesentlichen der Dicke der jeweiligen Piezo-Elemente entspricht. Außerdem ist es erforderlich, diese Zwischenfolie exakt zwischen den beiden Deckfolien zu plazieren, um die notwendige Zuordnung zwischen den Piezo-Elementen und den auf den Deckfolien ausgebildeten Leiterbahnen herzustellen.

Um diese Nachteile der bekannten Folientastatur zu vermeiden, wird mit einer älteren europäischen Patentanmeldung vorgeschlagen, anstelle der Verwendung einer Zwischenfolie eine der flexiblen Folien mit die Piezo-Elemente umgebenden Ringen zu versehen, deren axiale Dicke etwa der Scheibendicke der Piezo-Elemente entspricht. Die aus Kunststoff, vorzugsweise Kunststoffharzen bestehenden Ringe werden unmittelbar auf der Oberfläche der mit den Kontaktflächen und Leiterbahnen versehenen Folie aufgebracht. Es entfällt somit beim Zusammenbau der Folientastatur die Schwierigkeit der Zuordnung mehrerer Folien zueinander.

Der Erfindung liegt die **Aufgabe** zugrunde, eine Tastatur der eingangs definierten Art zu schaffen, die noch einfacher und preiswerter herstellbar ist, die Gefahr mangelhafter Kontaktierung vermeidet und auf das Aufbringen von Piezo-Elemente aufnehmenden Ringen auf eine der flexiblen Folien sowie auf die Anordnung einer zusätzlichen starren Trägerplatte verzichten kann.

Die **Lösung** dieser Aufgabenstellung durch die Erfindung ist dadurch gekennzeichnet, daß die Aussparungen für die scheibenförmigen Piezo-Elemente als abgestufte Ausnehmungen einer zugleich die Trägerplatte zur Aufnahme der durch Druckbelastung der Abdeckfolie im Bereich der Tastensymbole auf die Piezo-Elemente ausgeübten Biegekräfte bildenden Leiterplatte ausgebildet sind, wobei der größere Durchmesser der Ausnehmungen geringfügig größer als der Außendurchmesser der Metallplättchen und der kleinere Durchmesser etwa so groß wie der Durchmesser der durch eine Keramikscheibe gebildeten Piezo-Elemente und die Tiefe der Ausnehmungen im Bereich ihres größeren Durchmessers etwa so groß wie die Dicke der Metallplättchen und der Piezo-Elemente ist, und daß die Leiterplatte auf ihrer Unterseite mit Leiterbahnen versehen ist, von denen einige über Durchkontaktierungen unmittelbar mit den auf der ringförmigen Fläche der Ausnehmungen angeordneten Kontaktflächen für die Metallplättchen und die anderen ebenfalls über durch Kontaktierungen mit auf der Oberseite der Leiterplatte ausgebildeten Verbindungsflächen verbunden sind, die über Verbindungsflächen und an der Unterseite der Abdeckfolie mit den Kontaktflächen für die Piezo-Elemente verbunden sind.

Die erfindungsgemäß weitergebildete Tastatur hat den Vorteil, daß außer den Piezo-Elementen, die jeweils aus einer auf einem Metallplättchen angeordneten Keramikscheibe bestehen, nur zwei weitere Bauteile verwendet werden müssen, nämlich eine starre Leiterplatte mit abgestuften Ausnehmungen und eine dünne Abdeckfolie, wobei die Kontakte für die Piezo-Elemente über Leiterbahnen bewirkt werden, die auf beiden Seiten der Leiterplatte und auf der Unterseite der Abdeckfolie, vorzugsweise in bekannter Weise aus einer Kupferschicht mit verzinnter Oberfläche erzeugt werden und die mit Hilfe von Durchkontaktierungen in der Leiterplatte eine unmittelbare Verbindung mit den Kontaktflächen für die Metallplättchen und eine mittelbare Verbindung mit den Kontaktflächen für die Piezo-Elemente bewirken.

Die erfindungsgemäße Tastatur kommt somit mit einer geringstmöglichen Anzahl von Einzelteilen aus, die jeweils eine Mehrfachfunktion haben und sehr leicht einander zugeordnet werden können, so daß außer einer preiswerteren Herstellung eine höhere Funktionssicherheit erreicht wird.

Bei einer bevorzugten Ausführungsform der Erfindung sind die Leiterplatten aus Epoxydharz mit einer Dicke zwischen 2 mm und 5 mm und die Abdeckfolie aus einer Polyesterfolie mit einer Dicke in der Größenordnung von 0,1 mm hergestellt; die Leiterbahnen und Kontaktflächen werden durch eine Kupferschicht mit verzinnter Oberfläche mit einer Stärke von etwa 0,03 mm gebildet.

Auf der Zeichnung ist ein Ausführungsbeispiel der erfindungsgemäßen Tastatur dargestellt. Es zeigen:
- Fig. 1: einen vergrößert dargestellten Teilschnitt durch eine Tastatur im Bereich eines Piezo-Elements,
- Fig. 2: eine Draufsicht auf die mit Leiterbahnen versehene und mit Piezo-Elementen bestückte Leiterplatte,
- Fig. 3: eine Ansicht dieser Leiterplatte von unten mit den auf der Unterseite angeordneten Leiterbahnen und
- Fig. 4: eine Ansicht der Abdeckfolie von unten mit den auf der Unterseite ausgebildeten Kontaktflächen und Leiterbahnen.

Die anhand eines Ausführungsbeispiels dargestellte Tastatur besteht aus einer Leiterplatte 1 aus Epoxydharz, einer Abdeckfolie 2 aus Polyester und - beim Ausführungsbeispiel - aus drei Piezo-Elementen 3. Die Piezo-Elemente 3 werden beim Ausführungsbeispiel durch eine Keramikscheibe gebildet, die auf einem Metallplättchen 4 mit größerem Durchmesser angeordnet ist. Bei einer praktischen Ausführung hat die aus Epoxydharz bestehende Leiterplatte 1 eine Dicke von 3,2 mm und die aus einer Polyesterfolie bestehende Abdeckfolie 2 eine Dicke von 0,1 mm.

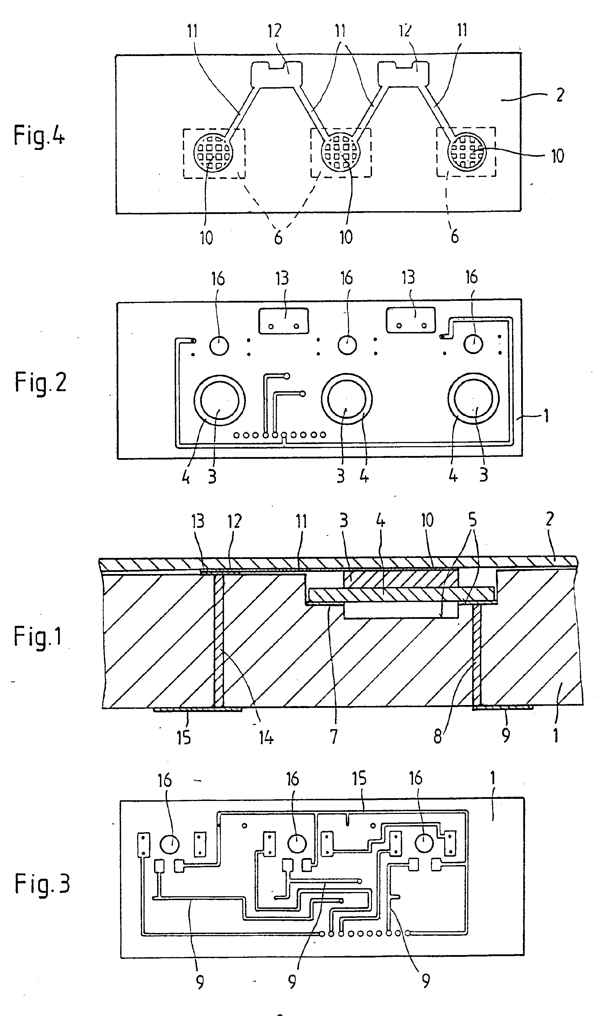

Zur unmittelbaren Aufnahme der Piezo-Elemente 3 ist die Leiterplatte 1 mit abgestuften Ausnehmungen 5 versehen. Der Durchmesser der größeren Stufe der Ausnehmung 5 ist geringfügig größer als der Außendurchmesser der Metallplättchen 4. Der Durchmesser der kleineren, aber tieferen Stufe der Ausnehmungen 5 entspricht etwa dem Durchmesser der die Piezo-Elemente 3 bildenden Keramikscheiben. Hierdurch wird erreicht, daß eine geringe Durchbiegung der mit den Piezo-Elementen 3 versehenen Metallplättchen 4 erfolgt, wenn die Abdeckfolie 2 im Bereich der Piezo-Elemente 3 mit Druck, vorzugsweise durch eine Fingerkuppe, belastet wird. Um das Feld für eine derartige Druckbelastung vorzugeben, ist die Abdeckfolie 2 mit Tastensymbolen 6 versehen, die in Fig. 4 angedeutet sind.

Um die durch die Piezo-Elemente 3 zu erzeugenden Signale an eine der Tastatur nachgeschaltete, auf der Zeichnung nicht dargestellte Auswerteschaltung weiterzuleiten, verfügt jedes Piezo-Element 3 über zwei Anschlüsse. Der eine Anschluß wird durch eine Kontaktfläche 7 gebildet, die auf der ringförmigen Fläche der Ausnehmung 5 zwischen der größeren und kleineren Stufe ausgebildet ist. Diese Kontaktfläche 7 steht über eine Durchkontaktierung 8 mit einer Leiterbahn 9 in Verbindung, die auf der Unterseite der Leiterplatte 1 ausgebildet ist und zu einem auf der Zeichnung nicht dargestellten Steckkontakt führt. Es ist somit eine unmittelbare Verbindung zwischen der auf der Unterseite der Leiterplatte 1 ausgebildeten Leiterbahn 9 über die Durchkontaktierung 8 und die Kontaktfläche 7 mit dem Metallplättchen 4 des Piezo-Elements 3 gegeben.

Der andere Anschluß erfolgt mittelbar über eine Kontaktfläche 10, die in der Art eines von einem Kreis umgebenden Gitters auf der Unterseite der Abdeckfolie 2 ausgebildet ist, wie dies in Fig. 4 dargestellt ist. Diese Kontaktflächen 10 stehen über Leiterbahnen 11 mit Verbindungsflächen 12 in Verbindung, welche bei einem Aufbringen der Abdeckfolie 2 auf die Leiterplatte 1 mit Verbindungsflächen 13 in Kontakt treten, die gemäß Fig. 2 auf der Oberseite der Leiterplatte 1 ausgebildet sind. Diese Verbindungsflächen 13 sind ihrerseits über Durchkontaktierungen 14 mit Leiterbahnen 15 verbunden, die wiederum auf der Unterseite der Leiterplatte 1 ausgebildet sind. Auf diese Weise erfolgt eine mittelbare Verbindung der Piezo-Elemente 3 mit den Leiterbahnen 15 der Leiterplatte 1, die ebenso wie die Leiterbahnen 9 mit einem nicht dargestellten Anschluß der Tastatur verbunden sind.

Die voranstehend beschriebene Leiterplatte 1 ist mit einer weiteren Anzahl von Leiterbahnen versehen, die für andere Zwecke zusätzlich auf der Leiterplatte 1 ausgebildet sind. Weiterhin weist die Leiterplatte 1 Bohrungen 16 auf, die im wesentlichen ihrer Befestigung dienen. Die Kontaktflächen 7 und 10, die Verbindungsflächen 12 und 13 und die Leiterbahnen 9 und 15 werden in bekannter Weise durch eine Kupferschicht mit verzinnter Oberfläche mit einer Gesamtstärke von etwa 0,03 mm gebildet.

### Bezugszeichenliste:

- 1: Leiterplatte
- 2: Abdeckfolie
- 3: Piezo-Element
- 4: Metallplättchen
- 5: Ausnehmung
- 6: Tastensymbol
- 7: Kontaktfläche
- 8: Durchkontaktierung
- 9: Leiterbahn
- 10: Kontaktfläche
- 11: Leiterbahn
- 12: Verbindungsfläche
- 13: Verbindungsfläche
- 14: Durchkontaktierung
- 15: Leiterbahn
- 16: Bohrung

## Patentansprüche

1. Tastatur mit einer Mehrzahl von scheibenförmigen, jeweils auf einem Metallplättchen (4) angeordneten Piezo-Elementen (3), die hinter einer mit Tastensymbolen (6) versehenen Abdeckfolie (2) in Aussparungen einer eine starre Trägerplatte umfassenden Unterlage und jeweils zwischen zwei Kontaktflächen (7,10) angeordnet sind, die über Leiterbahnen mit einem Anschluß der Tastatur verbunden sind,
**dadurch gekennzeichnet**,
daß die Aussparungen für die scheibenförmigen Piezo-Elemente (3) als abgestufte Ausnehmungen (5) einer zugleich die Trägerplatte zur Aufnahme der durch Druckbelastung der Abdeckfolie (2) im Bereich der Tastensymbole (6) auf die Piezo-Elemente (3) ausgeübten Biegekräfte bildenden Leiterplatte (1) ausgebildet sind, wobei der größere Durchmesser der Ausnehmungen (5) geringfügig größer als der Außendurchmesser der Metallplättchen (4) und der kleinere Durchmesser etwa so groß wie der Durchmesser der durch eine Keramikscheibe gebildeten Piezo-Elemente (3) und die Tiefe der Ausnehmungen (5) im Bereich ihres größeren Durchmessers etwa so groß wie die Dicke der Metallplättchen (4) und der Piezo-Elemente (3) ist, und daß die Leiterplatte (1) auf ihrer Unterseite mit Leiterbahnen (9,15) versehen ist, von denen einige über Durchkontaktierungen (8) unmittelbar mit den auf der ringförmigen Fläche der Ausnehmungen (5) angeordneten Kontaktflächen (7) für die Metallplättchen (4) und die anderen ebenfalls über Durchkontaktierungen (14) mit auf der Oberseite der Leiterplatte (1) ausgebildeten Verbindungsflächen (13) verbunden sind, die über Verbindungsflächen (12) und Leiterbahnen (11) an der Unterseite der Abdeckfolie (2) mit den Kontaktflächen (10) für die Piezo-Elemente (3) verbunden sind.

2. Tastatur nach Anspruch 1, dadurch gekennzeichnet, daß die Leiterplatte (1) aus Epoxydharz mit einer Dicke zwischen 2 mm und 5 mm und die Abdeckfolie (2) aus einer Polyesterfolie mit einer Dicke in der Größenordnung von 0,1 mm hergestellt und die Leiterbahnen (9,11,15) und Kontaktflächen (7,10) durch eine Kupferschicht mit verzinnter Oberfläche mit einer Stärke von etwa 0,03 mm gebildet sind.

## Claims

1. Keyboard with a plurality of disc-like piezo-elements (3) which are respectively arranged on a small metal plate (4) and are arranged behind a covering film (2), which is provided with key symbols (6), in recesses in a base which encloses a rigid supporting plate and between two contact surfaces (7, 10) in each case which are connected via conductor paths to a connection of the keyboard,
characterized in that
the recesses for the disc-like piezo-elements (3) take the form of stepped recesses (5) of a printed circuit board (1) which also forms the supporting plate for receiving the bending forces which are exerted on the piezo-elements (3) by subjecting the covering film (2) to pressure in the region of the key symbols (6), the larger diameter of the recesses (5) being slightly larger than the external diameter of the small metal plates (4) and the smaller diameter being approximately equal to the diameter of the piezo-elements formed by a ceramic disc and the depth of the recesses (5) being, in the region of their greater diameter, approximately equal to the thickness of the small metal plates (4) and the piezo-elements (3), and that the printed circuit board (1) is provided on its underside with strip conductors (9, 15), some of which are connected, via through-connections (8) directly to the contact surfaces (7), which are arranged on the annular surfaces of- the recesses (5), for the small metal plates (4) and the rest of which are also connected, via through-contacts (14), to the connecting surfaces (13) which are formed on the top of the printed circuit board (1) and are connected to the contact surfaces (10) for the piezo-elements (3) via connecting surfaces (12) and strip conductors (11) on the underside of the covering film (2).

2. Keyboard according to Claim 1, characterized in that the printed circuit board (1) is made of epoxy resin having a thickness of between 2 mm and 5 mm, that the covering film (2) is made of a polyester film having a thickness of the order of 0.1 mm and that the strip conductors (9, 11, 15) and contact surfaces are formed from a layer of copper with a tin-plated surface having a thickness of about 0.03 mm.

## Revendications

1. Clavier comprenant une pluralité d'éléments piézo-électriques (3) en forme de disques qui sont chacun montés sur une plaquette métallique (4) et qui sont disposés derrière un film de recouvrement (2) muni de symboles de touches (6), dans des évidements d'un support comprenant une plaque porteuse rigide et entre deux surfaces de contact (7, 10) qui sont reliées à une connexion du clavier par des pistes conductives, caractérisé en ce que les évidements destinés aux éléments piézo-électriques (3) en forme de disques sont conçus sous la forme d'évidements étagés (5) d'une plaque conductive (1) qui forme en même temps la plaque porteuse prévue pour absorber les forces de flexion exercées sur les éléments piézo-électriques (3) par la sollicitation en pression du film de recouvrement (2) dans la zone des symboles de touches (6), le plus grand diamètre des évidements (5) étant légèrement supérieur au diamètre extérieur des plaquettes métalliques (4) et le plus petit diamètre étant sensiblement égal au diamètre des éléments piézo-électriques (3) formés par un disque céramique, et la profondeur des évidements (5) dans la zone de leur plus grand diamètre étant sensiblement égale à l'épaisseur des plaquettes métalliques (4) et des éléments piézo-électriques (3), et en ce que le dessous de la plaque conductive (1) est muni de pistes conductives (9, 15) dont quelques-unes sont reliées directement, par des contacts traversants (8), aux surfaces de contact (7) disposées sur la surface annulaire des évidements (5) et destinées aux plaquettes métalliques (4), et dont les autres sont reliées, elles aussi par de contacts traversants (14), à des surfaces de liaison (13) qui se trouvent sur le dessus de la plaque conductive (1) et qui, par l'intermédiaire de surfaces de liaison (12) et de pistes conductives (11) disposées sur le dessous du film de recouvrement (2), sont reliées aux surfaces de contact (10) des éléments piézo-électriques (3).

2. Clavier selon la revendication 1, caractérisé en ce que la plaque conductive (1) est fabriquée en résine époxydique d'une épaisseur comprise entre 2 mm et 5 mm, et le film de recouvrement (2) est constitué d'un film en polyester d'une épaisseur de l'ordre de 0,1 mm, et les pistes conductives (9, 11, 15) et les surfaces de contact (7, 10) sont formées par une couche de cuivre à surface étamée d'une épaisseur d'environ 0,03 mm.
